# EUROPEAN PATENT APPLICATION

(11) **EP 2 077 545 A1**
(43) Date of publication of application: **08.07.2009**
(21) Application number: 08738628.0
(22) Date of filing: 23.04.2008
(51) Int. Cl.: G09G 3/28, G09G 3/20, H04N 5/66

(54) **PLASMA DISPLAY DEVICE**

(30) Priority: 25.04.2007 JP 2007115181
(71) Applicant: Panasonic Corporation, Kadoma-shi Osaka 571-8501 (JP)
(72) Inventor: TANIGUCHI, Tsukasa, c/o Panasonic Corp., IPROC, Chuo-ku, Osaka-shi, Osaka 540-6207 (JP)
(74) Representative: Pautex Schneider, Nicole Véronique
(86) International application number: PCT/JP2008/001060
(87) International publication number: WO 2008/132841

(57) **Abstract**

A plasma display device has a panel having a plurality of scan electrodes, and a drive circuit having a circuit board including a scan IC for applying scan pulses to the scan electrodes. The drive circuit divides a group of odd-numbered scan electrodes and a group of even-numbered scan electrodes individually. In the circuit board having the scan IC, a surface or layer to be mounted with a scan IC for applying scan pulses to the group of odd-numbered scan electrodes is different from a surface or layer to be mounted with a scan IC for applying scan pulses to the group of even-numbered scan electrodes.

## Description

### TECHNICAL FIELD

The present invention relates to a plasma display device employing a plasma display panel.

### BACKGROUND ART

A typical alternating-current surface discharge type panel used as a plasma display panel (hereinafter referred to as "panel") has many discharge cells between a front plate and a back plate that are faced to each other.

In the front plate, a plurality of display electrode pairs each of which is formed of a scan electrode and a sustain electrode are disposed in parallel on a front glass substrate. In the back plate, a plurality of data electrodes is disposed in parallel on a back glass substrate. The front plate and back plate are faced to each other so that the display electrode pairs and the data electrodes intersect three-dimensionally, and are sealed. Discharge gas is filled into a discharge space in the sealed product. Discharge cells are disposed in intersecting parts of the display electrode pairs and the data electrodes.

A plasma display device has such a panel and a drive circuit for driving each electrode of the panel. The drive circuit drives each of the scan electrodes, sustain electrodes, and data electrodes of the panel using a subfield method. In this method, one field period is divided into a plurality of subfields, and the subfields at which light is emitted are combined, thereby performing gray scale display. Each subfield has an initializing period, an address period, and a sustain period. In the initializing period, initializing discharge occurs, and a wall charge required for a subsequent address operation is formed on each electrode. In the address period, scan pulses are sequentially applied to scan electrodes, and an address pulse is applied to a data electrode of a discharge cell where display is to be performed to cause address discharge. In the sustain period, a sustain pulse is alternately applied to the display electrode pairs, sustain discharge is caused, and light is emitted, thereby displaying an image.

When the panel is driven using the subfield method, the wall charge required for the address operation is reduced only by applying the address pulse to the data electrode, namely without applying the scan pulses to the scan electrodes. As a result, address discharge can become unstable. As a method of addressing the problem, the following driving method is disclosed in patent document 1, for example. In this driving method, the scan electrodes are divided into four scan electrode groups, the address period is divided into four periods when the scan pulses are sequentially applied to the scan electrodes belonging to each scan electrode group, and higher voltage is applied to the scan electrode group to which the scan pulses are not applied than to the scan electrode group to which the scan pulses are applied.

In this driving method, however, the timing when voltage difference between adjacent scan electrodes becomes excessive occurs, and spark can occur between the electrode terminals of the panel or between wiring patterns of the printed board. Short circuit or the like can occur in the extraction section of a scan electrode of the panel due to migration. Driving voltage is supplied from a scan electrode drive circuit corresponding to each scan electrode group, so that there is the following problem or the like. Slight difference occurs between driving voltage waveforms of the scan electrode groups, a contour occurs in an image display region corresponding to the boundary between the scan electrode groups, and the image display quality reduces.
[Patent document 1] Japanese Patent Unexamined Publication No. 2003-43989

### SUMMARY OF THE INVENTION

The present invention addresses the above-mentioned problems, and provides a plasma display device where spark or short circuit does not occur between the electrode terminals of the panel or between the wiring patterns of the printed board, the image display quality is not reduced, and stable address discharge can be generated by preventing reduction of the wall charge.

The plasma display device has the following elements:
a plasma display panel having a plurality of scan electrodes; and
a drive circuit having a circuit board having a scan integrated circuit (IC) for applying scan pulses to the plurality of scan electrodes.
The drive circuit divides a group of odd-numbered scan electrodes and a group of even-numbered scan electrodes individually. In the circuit board having the scan IC, a scan IC for applying scan pulses to the group of odd-numbered scan electrodes is mounted on one surface of the circuit board, and a scan IC for applying scan pulses to the group of even-numbered scan electrodes is mounted on the other surface.

The plasma display device has the following elements:
a plasma display panel having a plurality of scan electrodes; and
a drive circuit having a circuit board having a scan IC for applying scan pulses to a plurality of scan electrodes.
The drive circuit divides a group of odd-numbered scan electrodes and a group of even-numbered scan electrodes individually. The circuit board having the scan IC is a multi-layer circuit board having two wiring layers or more. The wiring layer for wiring the output section of the scan IC for applying the scan pulses to the group of odd-numbered scan electrodes is different from the wiring layer for wiring the output section of the scan IC for applying the scan pulses to the group of even-numbered scan electrodes.

### BRIEF DESCRIPTION OF DRAWINGS

Fig. 1 is an exploded perspective view showing a structure of a panel in accordance with an exemplary embodiment of the present invention.
Fig. 2 is an electrode array diagram of the panel in accordance with the exemplary embodiment.
Fig. 3 is a circuit block diagram of a plasma display device in accordance with the exemplary embodiment.
Fig. 4 is a waveform chart of driving voltage applied to each electrode of the panel in accordance with the exemplary embodiment.
Fig. 5 is another waveform chart of driving voltage applied to each electrode of the panel in accordance with the exemplary embodiment.
Fig. 6 is a circuit diagram showing the configuration of a scan pulse generating section of the plasma display device in accordance with the exemplary embodiment.
Fig. 7 is an exploded perspective view showing one example of the configuration of the plasma display device in accordance with the exemplary embodiment.
Fig. 8A is a diagram showing a circuit board having a scan IC in accordance with the exemplary embodiment.
Fig. 8B is a diagram showing a circuit board having a scan IC in accordance with the exemplary embodiment.
Fig. 9 is a diagram showing a state of the wiring of the circuit board in accordance with the exemplary embodiment.

### REFERENCE MARKS IN THE DRAWINGS

10 panel
22 scan electrode
23 sustain electrode
24 display electrode pair
32 data electrode
41 image signal processing circuit
42a, 42b data electrode drive circuit
43 scan electrode drive circuit
44 sustain electrode drive circuit
45 timing generating circuit
50 scan pulse generating section
51, 52 switch
53 odd-numbered electrode output section
54 even-numbered electrode output section
55 (1), 55 (3), ..., 56 (2), 56 (4), ... output section
100 plasma display device
531 through 550 scan IC
561 through 568 connector

### DETAILED DESCRIPTION OF PREFERRED EMBODIMENTS

A plasma display device in accordance with an exemplary embodiment of the present invention will be described hereinafter with reference to the accompanying drawings.

### (EXEMPLARY EMBODIMENT)

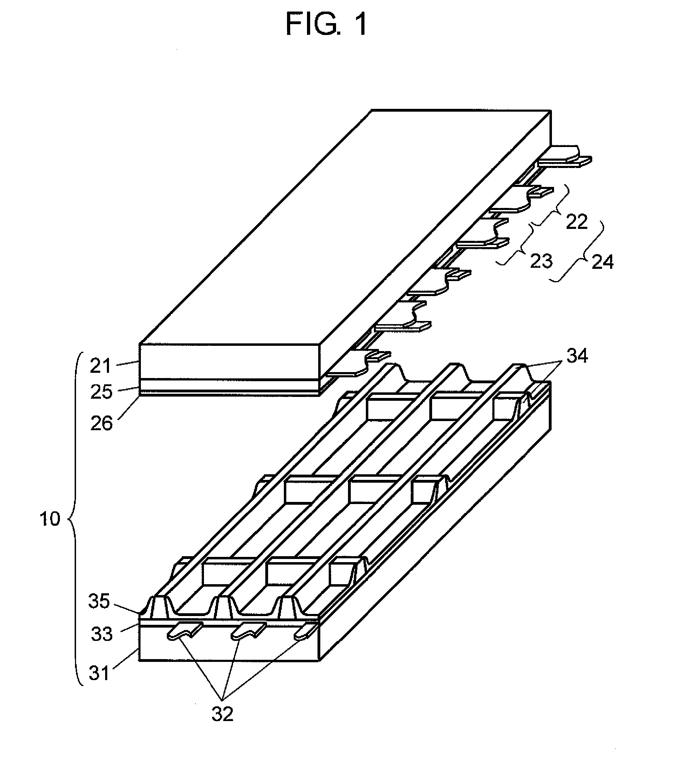

Fig. 1 is an exploded perspective view showing a structure of panel 10 in accordance with the exemplary embodiment of the present invention. A plurality of display electrode pairs 24 formed of scan electrodes 22 and sustain electrodes 23 are disposed on glass-made front substrate 21. Dielectric layer 25 is formed so as to cover scan electrodes 22 and sustain electrodes 23, and protective layer 26 is formed on dielectric layer 25. A plurality of data electrodes 32 are formed on back substrate 31, dielectric layer 33 is formed so as to cover data electrodes 32, and mesh barrier ribs 34 are formed on dielectric layer 33. Phosphor layers 35 for emitting lights of respective colors of red, green, and blue are formed on the side surfaces of barrier ribs 34 and on dielectric layer 33.

Front substrate 21 and back substrate 31 are faced to each other so that display electrode pairs 24 cross data electrodes 32 with a micro discharge space sandwiched between them. The outer peripheries of front substrate 21 and back substrate 31 are sealed by a sealing material such as glass frit. The discharge space is filled with discharge gas, for example, mixed gas of neon and xenon. The discharge space is partitioned into a plurality of sections by barrier ribs 34. Discharge cells are formed in the intersecting parts of display electrode pairs 24 and data electrodes 32. The discharge cells discharge and emit light to display an image.

The structure of panel 10 is not limited to the above-mentioned one, but may be a structure having striped barrier ribs, for example.

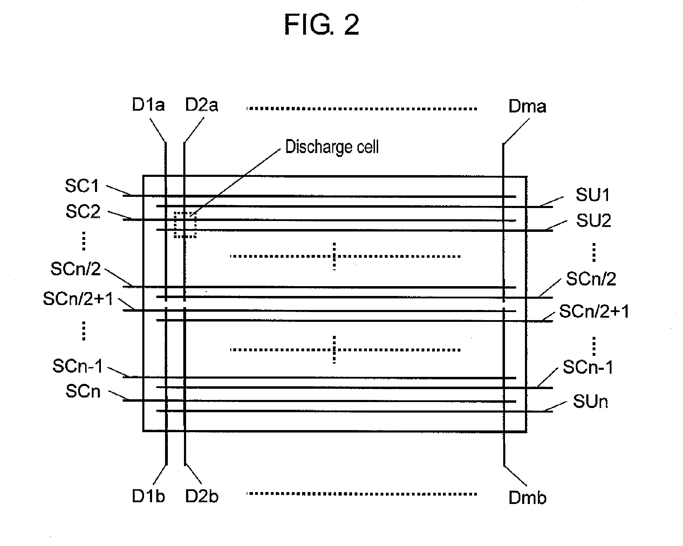

Fig. 2 is an electrode array diagram of panel 10 in accordance with the exemplary embodiment of the present invention. In panel 10, n (even number) scan electrode SC1 through scan electrode SCn (scan electrodes 22 in Fig. 1) and n sustain electrode SU1 through sustain electrode SUn (sustain electrodes 23 in Fig. 1) long in the column direction are arranged. On the upper half of panel 10, m data electrode D1a through data electrode Dma (data electrodes 32 in Fig. 1) long in the row direction are arranged. On the lower half of panel 10, m data electrode D1b through data electrode Dmb (data electrodes 32 in Fig. 1) long in the row direction are arranged. Each discharge cell is formed in the intersecting part of a pair of scan electrode SCi (i is 1 through n) and sustain electrode SUi and one data electrode Dja (j is 1 through m) or data electrode Djb (j is 1 through m). In other words, the number of discharge cells formed in the discharge space is 2xmxn. In the present embodiment, as discussed above, panel 10 having the data electrodes divided into data electrode Dja and data electrode Djb is described as an example. The present invention is not limited to this, and data electrodes Dj may not be divided.

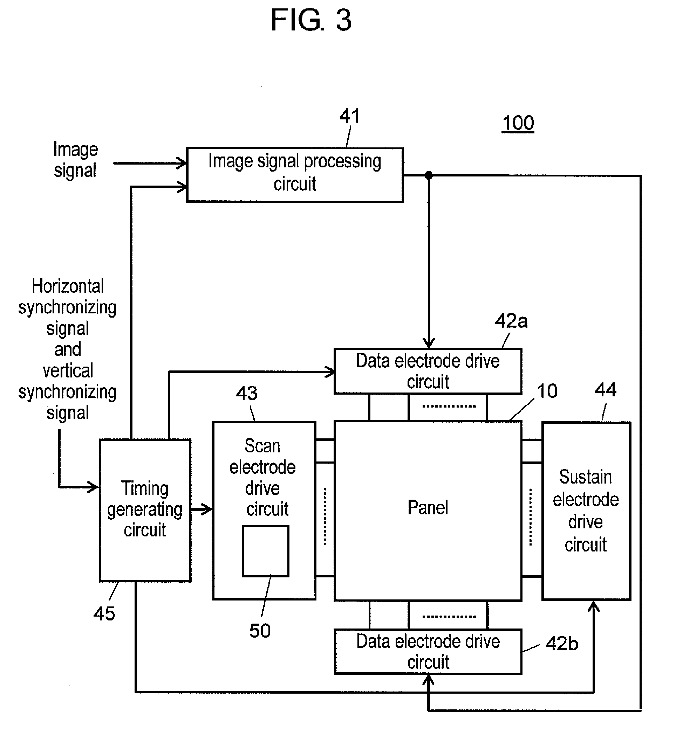

Fig. 3 is a circuit block diagram of plasma display device 100 in accordance with the exemplary embodiment of the present invention. Plasma display device 100 has the following elements:
panel 10;
image signal processing circuit 41;
data electrode drive circuit 42a;
data electrode drive circuit 42b;
scan electrode drive circuit 43;
sustain electrode drive circuit 44;
timing generating circuit 45; and
a power supply section (not shown) for supplying power required for each circuit block.

Image signal processing circuit 41 converts an input image signal into image data that indicates emission or non-emission of light in each subfield. Data electrode drive circuit 42a converts the image data of each subfield into a signal corresponding to each of data electrode D1a through data electrode Dma, and drives each of data electrodes D1a through data electrode Dma. Data electrode drive circuit 42b converts the image data of each subfield into a signal corresponding to each of data electrode D1b through data electrode Dmb, and drives each of data electrode D1b through data electrode Dmb.

Timing generating circuit 45 generates various timing signals for controlling the operation of each circuit block based on a horizontal synchronizing signal and a vertical synchronizing signal, and supplies them to respective circuit blocks. Scan electrode drive circuit 43 has a scan pulse generating section 50 for generating various voltages and scan pulses to be applied to scan electrode SC1 through scan electrode SCn in the address period, and drives each of scan electrode SC1 through scan electrode SCn based on the timing signal. Sustain electrode drive circuit 44 drives sustain electrode SU1 through sustain electrode SUn based on a timing signal.

Next, a driving voltage waveform for driving panel 10 and its operation are described. Plasma display device 100 performs gray scale display by a subfield method. In this subfield method, one field period is divided into a plurality of subfields, and emission and non-emission of light of each discharge cell are controlled in each subfield. Each subfield has an initializing period, an address period, and a sustain period. In the initializing period, initializing discharge is performed to form, on each electrode, a wall charge required for a subsequent address discharge. In the address period, address discharge is selectively caused in a discharge cell to emit light, thereby forming a wall charge. In the sustain period, sustain discharge is caused in the discharge cell having caused address discharge, thereby emitting light.

In the exemplary embodiment, the scan electrodes are divided into a group of odd-numbered scan electrodes and a group of even-numbered scan electrodes, and are driven. The address period is divided into an odd address period (hereinafter referred to as "odd period") and an even address period (hereinafter referred to as "even period"). In the odd period, scan pulses are sequentially applied to odd-numbered scan electrode SC1, scan electrode SC3, ... , and scan electrode SCn-1. In the even period, scan pulses are sequentially applied to even-numbered scan electrode SC2, scan electrode SC4, ... , and scan electrode SCn. In this embodiment, it is assumed that the even period is firstly arranged and then the odd period is arranged to form an address period. The present invention is not limited to this order.

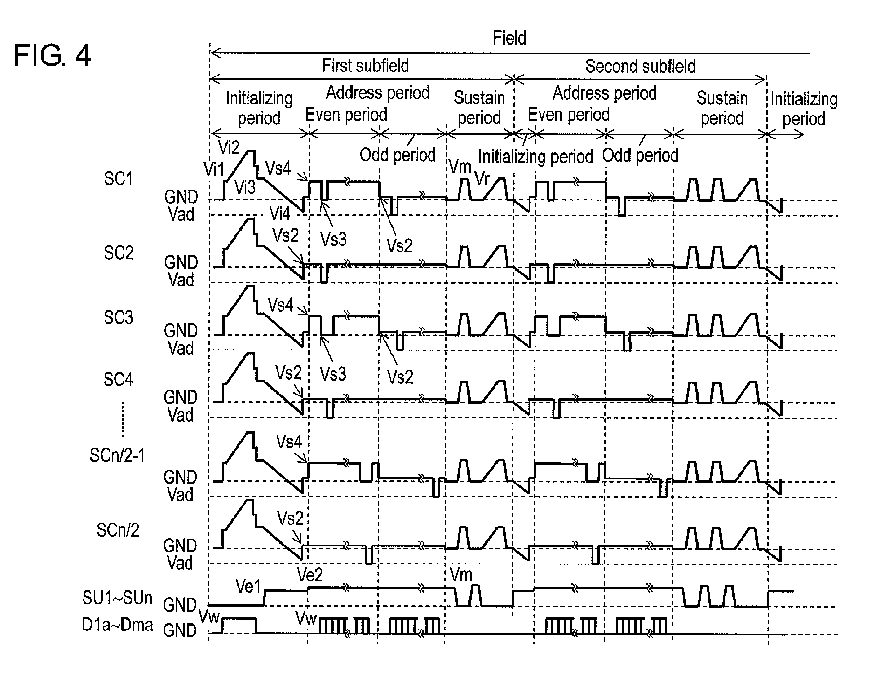

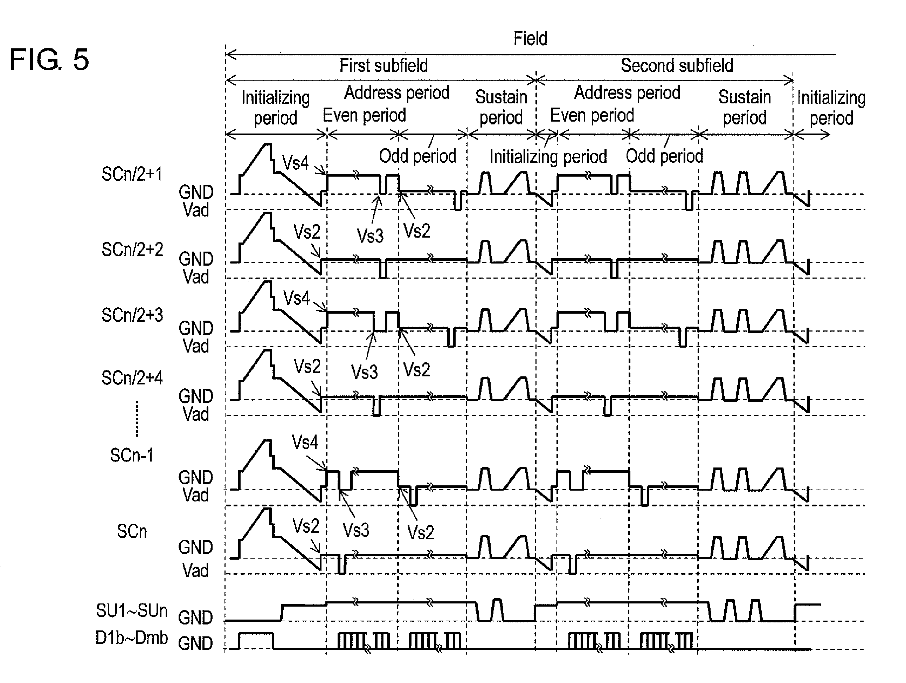

Fig. 4 and Fig. 5 show a driving voltage waveform applied to each electrode of panel 10 in accordance with the exemplary embodiment of the present invention. Fig. 4 shows the driving voltage waveform applied to each of data electrode D1a through data electrode Dma and scan electrode SC1 through scan electrode SCn/2 on the upper half of panel 10. Fig. 5 shows the driving voltage waveform applied to each of data electrode D1b through data electrode Dmb and scan electrode SCn/2+1 through scan electrode SCn on the lower half of panel 10. One field period is formed of 10 subfields, for example, but Fig. 4 and Fig. 5 show the driving voltage waveforms of two subfields.

In the first half of the initializing period of the first subfield, address pulse voltage Vw is applied to data electrode D1a through data electrode Dma and data electrode D1b through data electrode Dmb. Voltage 0 (V) is applied to sustain electrode SU1 through sustain electrode SUn. A ramp waveform voltage is applied to scan electrode SC1 through scan electrode SCn. Here, the ramp waveform voltage gradually increases from voltage Vi1, which is not higher than a discharge start voltage, to voltage Vi2, which is higher than the discharge start voltage, with respect to sustain electrode SU1 through sustain electrode SUn. While this ramp waveform voltage increases, feeble initializing discharge occurs between scan electrode SC1 through scan electrode SCn and sustain electrode SU1 through sustain electrode SUn, feeble initializing discharge occurs between scan electrode SC1 through scan electrode SCn and data electrode D1a through data electrode Dma, and feeble initializing discharge occurs between scan electrode SC1 through scan electrode SCn and data electrode D1b through data electrode Dmb. Negative wall voltage is accumulated on scan electrode SC1 through scan electrode SCn, and positive wall voltage is accumulated on data electrode D1a through data electrode Dma, data electrode D1b through data electrode Dmb, and sustain electrode SU1 through sustain electrode SUn. Here, the wall voltage on the electrodes means the voltage generated by the wall charges accumulated on the dielectric layer covering the electrodes, the protective layer, and the phosphor layer.

In the last half of the initializing period, voltage 0 (V) is applied to data electrode D1a through data electrode Dma and data electrode D1b through data electrode Dmb, and positive voltage Ve1 is applied to sustain electrode SU1 through sustain electrode SUn. A ramp waveform voltage is applied to scan electrode SC1 through scan electrode SCn. Here, the ramp waveform voltage gradually decreases from voltage Vi3, which is not higher than the discharge start voltage, to voltage Vi4, which is higher than the discharge start voltage, with respect to sustain electrode SU1 through sustain electrode SUn. While the ramp waveform voltage decreases, feeble initializing discharge occurs between scan electrode SC1 through scan electrode SCn and sustain electrode SU1 through sustain electrode SUn, feeble initializing discharge occurs between scan electrode SC1 through scan electrode SCn and data electrode D1a through data electrode Dma, and feeble initializing discharge occurs between scan electrode SC1 through scan electrode SCn and data electrode D1b through data electrode Dmb. Then, the negative wall voltage on scan electrode SC1 through scan electrode SCn and the positive wall voltage on sustain electrode SU1 through sustain electrode SUn are reduced, positive wall voltage on data electrode D1a through data electrode Dma and data electrode D1b through data electrode Dmb is adjusted to a value suitable for the address operation.

The first half of the initializing period may be omitted in some subfield of the subfields constituting one field. In this case, an initializing operation is selectively performed in the discharge cell where the sustain discharge has been performed in the next previous sustain discharge. Fig. 4 shows a driving voltage waveform where an initializing operation having the first half and the last half is performed in the initializing period of the first subfield, and an initializing operation having only the last half is performed in the initializing period of the second subfield or later.

In the subsequent address period, in the present embodiment, address operation is simultaneously performed in the upper half discharge cell of panel 10 and in the lower half discharge cell of panel 10. First, the address operation of the discharge cells on the upper half of panel 10 in the even period is described.

At the beginning of the even period, voltage Ve2 is applied to sustain electrode SU1 through sustain electrode SUn. Fourth voltage Vs4 is applied to each of odd-numbered scan electrode SC1, scan electrode SC3, ... , and scan electrode SCn/2-1, and second voltage Vs2 is applied to each of even-numbered scan electrode SC2, scan electrode SC4, ... , and scan electrode SCn/2. Here, fourth voltage Vs4 is higher than second voltage Vs2.

Next, in order to apply a negative scan pulse to second scan electrode SC2, scan pulse voltage Vad as first voltage is applied. Positive address pulse voltage Vw is applied to data electrode Dka (k is 1 through m), of data electrode D1a through data electrode Dma, in the discharge cell to emit light first from the upside. At this time, in the present embodiment, third voltage Vs3 lower than fourth voltage Vs4 is applied to the scan electrodes adjacent to scan electrode SC2, namely first scan electrode SC1 and third scan electrode SC3. This operation is performed to prevent excessive voltage difference from being applied between adjacent scan electrode SC1 and scan electrode SC2, and between scan electrode SC2 and scan electrode SC3.

The voltage difference in the intersecting part of scan electrode SC2 and data electrode Dka of the discharge cell to which address pulse voltage Vw is applied is obtained by adding the difference between the wall voltage on data electrode Dka and that on scan electrode SC2 to the difference (Vw - Vad) of the external applied voltage. The obtained voltage difference exceeds the discharge start voltage. Address discharge occurs between data electrode Dka and scan electrode SC2 and between sustain electrode SU2 and scan electrode SC2. Positive wall voltage is accumulated on scan electrode SC2, negative wall voltage is accumulated on sustain electrode SU2, and negative wall voltage is also accumulated on data electrode Dka. Thus, an address operation is performed that causes address discharge in the discharge cell to emit light second from the upside and accumulates wall voltage on each electrode. The voltage in the intersecting parts of scan electrode SC2 and data electrode D1a through data electrode Dma to which address pulse voltage Vw is not applied does not exceed the discharge start voltage, so that address discharge does not occur.

Then, scan pulse voltage Vad as the first voltage is applied to fourth scan electrode SC4, and positive address pulse voltage Vw is applied to data electrode Dka, of data electrode D1a through data electrode Dma, in the discharge cell to emit light fourth from the upside. At this time, third voltage Vs3 is applied to third scan electrode SC3 and fifth scan electrode SC5 that are adjacent to scan electrode SC4. Then, the address operation is performed where address discharge occurs between data electrode Dka and scan electrode SC4 of this discharge cell, address discharge occurs between sustain electrode SU4 and scan electrode SC4, and wall voltage is accumulated on each electrode.

Regarding even-numbered scan electrode SC6, scan electrode SC8, ... , and scan electrode SCn/2, an address operation is performed similarly. At this time, third voltage Vs3 is also applied to odd-numbered scan electrode SCp-1 (p is even number, 1 < p < n) and scan electrode SCp+1 that are adjacent to even-numbered scan electrode SCp where the address operation is performed.

In the address operation of the discharge cells on the lower half of panel 10, similarly, voltage Ve2 is applied to sustain electrode SU1 through sustain electrode SUn. Fourth voltage Vs4 is applied to each of odd-numbered scan electrode SCn/2+1, scan electrode SCn/2+3, ... , and scan electrode SCn-1. Second voltage Vs2 is applied to each of even-numbered scan electrode SCn/2+2, scan electrode SCn/2+4, ... , and scan electrode SCn. Then, as shown in Fig. 5, scan pulses are sequentially applied to even-numbered scan electrode SCn, scan electrode SCn-2, ... , and scan electrode SCn/2+2. Third voltage Vs3 is also applied to odd-numbered scan electrode SCp-1 and scan electrode SCp+1 that are adjacent to even-numbered scan electrode SCp where the address operation is performed.

In the even period of the present embodiment, as shown in Fig. 4 and Fig. 5, scan pulses are sequentially applied to scan electrode SC2, scan electrode SC4, ... , and scan electrode SCn/2 on the upper half of panel 10 from the upside toward the downside. Scan pulses are sequentially applied to scan electrode SCn/2+2, scan electrode SCn/2+4, ... , and scan electrode SCn on the lower half of panel 10 from the downside toward the upside. Then, scan pulses are simultaneously applied to scan electrode SC2 and scan electrode SCn, scan pulses are simultaneously applied to scan electrode SC4 and scan electrode SCn-2, and so on. Finally, scan pulses are simultaneously applied to scan electrode SCn/2 and scan electrode SCn/2+2. However, the present invention is not limited to this. In other words, scan pulses may be sequentially applied to scan electrode SC2, scan electrode SC4, ... , and scan electrode SCn/2 on the upper half of panel 10 from the upside toward the downside, and to scan electrode SCn/2+2, scan electrode SCn/2+4, ... , and scan electrode SCn on the lower half similarly from the upside toward the downside. Scan pulses may be sequentially applied to scan electrode SC2, scan electrode SC4, ... , and scan electrode SCn/2 on the upper half of panel 10 from the downside toward the upside, and scan pulses may be sequentially applied to scan electrode SCn/2+2, scan electrode SCn/2+4, ... , and scan electrode SCn on the lower half from the upside toward the downside.

In the subsequent odd period, on the upper half of panel 10, second voltage Vs2 is applied to odd-numbered scan electrode SC1, scan electrode SC3, ... , and scan electrode SCn/2-1, and second voltage Vs2 is applied to even-numbered scan electrode SC2, scan electrode SC4, ... , and scan electrode SCn/2, in the present embodiment. However, fourth voltage Vs4 may be applied to the even-numbered scan electrodes.

Next, scan pulse voltage Vad as the first voltage for applying the negative scan pulse is applied to first scan electrode SC1. Positive address pulse voltage Vw is applied to data electrode Dka, of data electrode D1a through data electrode Dma, in the discharge cell to emit light first from the upside. Then, the voltage difference in the intersecting part of data electrode Dka of the discharge cell and scan electrode SC1 exceeds the discharge start voltage, and an address operation of causing address discharge in the discharge cell to emit light first from the upside and accumulating wall voltage on each electrode is performed. Then, scan pulse voltage Vad is applied to third scan electrode SC3, and positive address pulse voltage Vw is applied to data electrode Dka in the discharge cell to emit light third from the upside. Then, address discharge occurs in the discharge cell. Regarding odd-numbered scan electrode SC5, scan electrode SC7, ... , and scan electrode SCn/2-1, an address operation is performed similarly.

In the address operation of the discharge cells on the lower half of panel 10, similarly, second voltage Vs2 is applied to odd-numbered scan electrode SCn/2+1, scan electrode SCn/2+3, ... , and scan electrode SCn-1. Second voltage Vs2 is applied to even-numbered scan electrode SCn/2+2, scan electrode SCn/2+4, ... , and scan electrode SCn. Then, as shown in Fig. 5, scan pulses are sequentially applied to odd-numbered scan electrode SCn-1, scan electrode SCn-3, ... , and scan electrode SCn/2+1, and address operation is performed.

In the odd period, also, scan pulses are sequentially applied to scan electrode SC1, scan electrode SC3, ... , and scan electrode SCn/2-1 on the upper half of panel 10 from the upside toward the downside. Scan pulses are sequentially applied to scan electrode SCn/2+1, scan electrode SCn/2+3, ... , and scan electrode SCn-1 on the lower half of panel 10 from the downside toward the upside. Then, scan pulses are simultaneously applied to scan electrode SC1 and scan electrode SCn-1, scan pulses are simultaneously applied to scan electrode SC3 and scan electrode SCn-3, and so on. Finally, scan pulses are simultaneously applied to scan electrode SCn/2-1 and scan electrode SCn/2+1. However, the present invention is not limited to this, and the applying order of the scan pulses can be set arbitrarily.

In the above-mentioned description, the odd period is disposed after the even period. However, the even period may be disposed after the odd period, and this order is switched appropriately.

In the subsequent sustain period, positive sustain pulse voltage Vm is firstly applied to scan electrode SC1 through scan electrode SCn, and voltage 0 (V) is applied to sustain electrode SU1 through sustain electrode SUn. In the discharge cell having caused the address discharge, the voltage difference between scan electrode SCi and sustain electrode SUi is obtained by adding the difference between the wall voltage on scan electrode SCi and that on sustain electrode SUi to sustain pulse voltage Vm. The obtained voltage difference exceeds the discharge start voltage. Sustain discharge occurs between scan electrode SCi and sustain electrode SUi, and ultraviolet rays generated at this time cause phosphor layer 35 to emit light. Negative wall voltage is accumulated on scan electrode SCi, and positive wall voltage is accumulated on sustain electrode SUi. Positive wall voltage is also accumulated on data electrode Dka and data electrode Dkb. In the discharge cell where address discharge does not occur in the address period, sustain discharge does not occur, and the wall voltage at the completion of the initializing period is kept.

Subsequently, voltage 0 (V) is applied to scan electrode SC1 through scan electrode SCn, and sustain pulse voltage Vm is applied to sustain electrode SU1 through sustain electrode SUn. In the discharge cell having caused the sustain discharge, the voltage difference between sustain electrode SUi and scan electrode SCi exceeds the discharge start voltage. Therefore, sustain discharge occurs between sustain electrode SUi and scan electrode SCi again. Negative wall voltage is accumulated on sustain electrode SUi, and positive wall voltage is accumulated on scan electrode SCi. Hereinafter, similarly, as many sustain pulses as the number corresponding to the luminance weight are alternately applied to scan electrode SC1 through scan electrode SCn and sustain electrode SU1 through sustain electrode SUn, and potential difference is caused between the electrodes of the display electrode pairs. Thus, sustain discharge occurs continuously in the discharge cell that has caused the address discharge in the address period.

At the end of the sustain period, a ramp waveform voltage that gradually increases to voltage Vr is applied to scan electrode SC1 through scan electrode SCn. While the positive wall voltage is kept on data electrode Dka and data electrode Dkb, wall voltages on scan electrode SCi and sustain electrode SUi are eliminated. Thus, the sustain operation in the sustain period is completed.

Next, a detailed configuration of scan pulse generating section 50 is described. In the present embodiment, it is assumed that the difference between second voltage Vs2 and scan pulse voltage Vad as the first voltage is equal to the difference between fourth voltage Vs4 and third voltage Vs3. This voltage difference is hereinafter referred to as voltage Vscn. In other words, (Vs2 - Vad) = (Vs4 - Vs3) = Vscn. The first voltage Vs1 is Vad, so that second voltage Vs2 is (Vad + Vscn) and fourth voltage Vs4 is (Vs3 + Vscn). In the present embodiment, the value of scan pulse voltage Vad is -140 (V), that of voltage Vscn is 150 (V), and that of third voltage Vs3 is 0 (V). However, these voltages are one example. Preferably, these voltages are set to optimal values in response to the characteristic or the like of panel 10.

Panel 10 used in the present embodiment is a high definition panel, and n is 1080. In other words, this panel has 1080 scan electrode SC1 through scan electrode SC1080 and sustain electrode SU1 through sustain electrode SU1080.

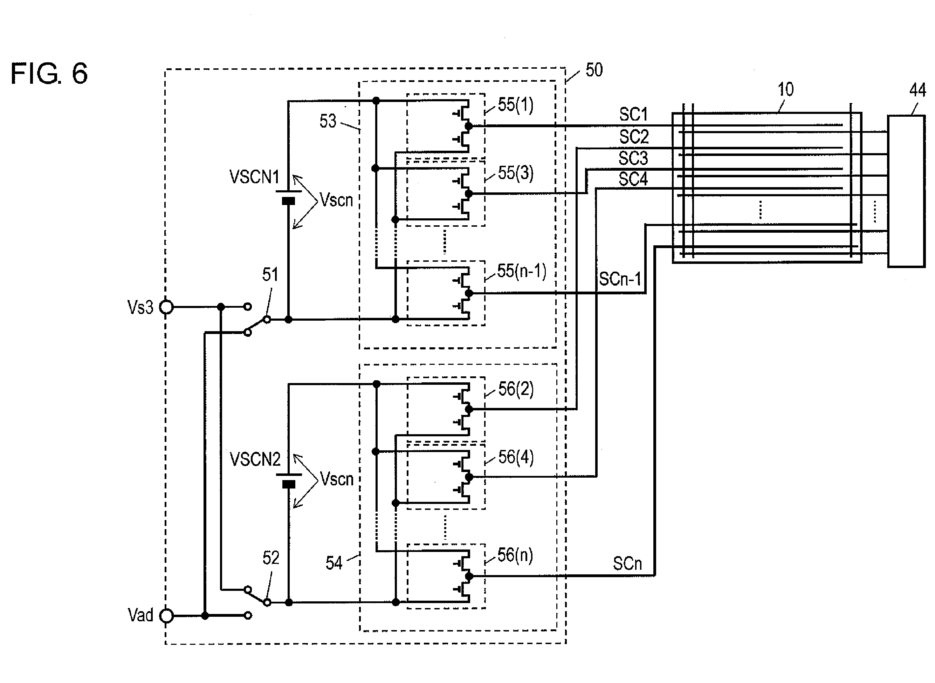

Fig. 6 is a circuit diagram showing the configuration of scan pulse generating section 50 of plasma display device 100 in accordance with the exemplary embodiment of the present invention. Fig. 6 also shows panel 10 and sustain electrode drive circuit 44. Scan pulse generating section 50 has the following elements:
odd-numbered electrode output section 53;
even-numbered electrode output section 54;
floating power supply VSCN1;
floating power supply VSCN2;
switch 51; and
switch 52.
Odd-numbered electrode output section 53 outputs driving voltage to be applied to odd-numbered scan electrode SC1, scan electrode SC3, ... , and scan electrode SC1079. In Fig. 6, scan electrode SC1079 is referred to as "SCn-1". Even-numbered electrode output section 54 outputs driving voltage to be applied to even-numbered scan electrode SC2, scan electrode SC4, ... , and scan electrode SC1080. In Fig. 6, scan electrode SC1080 is referred to as "SCn". Floating power supply VSCN1 supplies the power to odd-numbered electrode output section 53. Switch 51 connects the lower voltage side of floating power supply VSCN1 to scan pulse voltage Vad as the first voltage or the third voltage Vs3. Floating power supply VSCN2 supplies the power to even-numbered electrode output section 54. Switch 52 connects the lower voltage side of floating power supply VSCN2 to scan pulse voltage Vad as the first voltage or the third voltage Vs3. In the present embodiment, the voltages of both floating power supply VSCN1 and floating power supply VSCN2 are equal to voltage Vscn.

In Fig. 6, a circuit for generating the driving voltage waveform in the initializing period and sustain period is omitted.

Odd-numbered electrode output section 53 has output section 55 (1), output section 55 (3), ... , and output section 55 (1079) for applying the voltage on the lower voltage side of floating power supply VSCN1 or the voltage on the higher voltage side to odd-numbered scan electrode SC1, scan electrode SC3, ... , and scan electrode SC1079, respectively. Each of output section 55 (1), output section 55 (3), ... , and output section 55 (1079) has a switching element for outputting the voltage on the higher voltage side of floating power supply VSCN1, and a switching element for outputting the voltage on the lower voltage side of floating power supply VSCN1.

Even-numbered electrode output section 54, similarly, has output section 56 (2), output section 56 (4), ... , and output section 56 (1080) for applying the voltage on the lower voltage side of floating power supply VSCN2 or the voltage on the higher voltage side to even-numbered scan electrode SC2, scan electrode SC4, ... , and scan electrode SC1080, respectively. Each of output section 56 (2), output section 56 (4), ... , and output section 56 (1080) has a switching element for outputting the voltage on the higher voltage side of floating power supply VSCN2, and a switching element for outputting the voltage on the lower voltage side of floating power supply VSCN2.

Floating power supply VSCN1 and floating power supply VSCN2 may be configured using a DC-DC converter or the like, for example. However, they can be easily configured using a bootstrap circuit having a diode and a capacitor.

Output section 55 (1), output section 55 (3), ... , and output section 55 (539) of odd-numbered electrode output section 53 are collected into a plurality of blocks and are integrated as a circuit. Similarly, output section 56 (2), output section 56 (4), ... , and output section 56 (540) of even-numbered electrode output section 54 are collected into a plurality of blocks and are integrated as a circuit. This integrated circuit (IC) is referred to as "scan IC". In the present embodiment, 64 output sections are integrated as one monolithic IC. Odd-numbered electrode output section 53 is configured using 10 scan ICs, and similarly even-numbered electrode output section 54 is configured using 10 scan ICs. Thus, integrating many output sections allows a compact circuit to be formed, and reduces the mounting area. Using the monolithic IC as the IC makes the mounting area smaller, and it is further preferable.

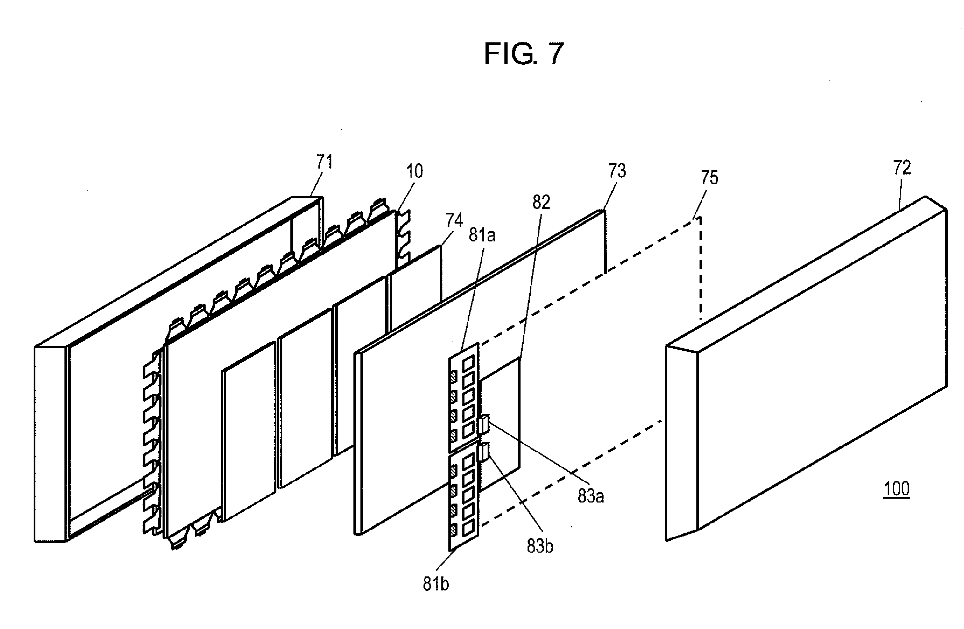

Fig. 7 is an exploded perspective view showing one example of the configuration of plasma display device 100 in accordance with the exemplary embodiment of the present invention. Plasma display device 100 has the following elements:
panel 10;
front frame 71 and back cover 72 for storing panel 10;
chassis 73 for holding panel 10; and
thermally conductive sheet 74 for dissipating the heat generated by panel 10 to chassis 73.
Plasma display device 100 also has scan electrode drive circuit 43, sustain electrode drive circuit 44, timing generating circuit 45, and circuit board group 75 having a drive circuit for driving panel 10 such as a power supply circuit. Circuit board group 75 is disposed on chassis 73.

Scan electrode drive circuit 43 shown in Fig. 3 is divided into circuit board 8a, circuit board 81b, and circuit board 82, and is mounted. Circuit board 81a is mounted with scan ICs for driving scan electrode SC1 through scan electrode SC540, namely five scan IC 531 through scan IC 535 of odd-numbered electrode output section 53 and five scan IC 541 through scan IC 545 of even-numbered electrode output section 54. Circuit board 81b is mounted with scan ICs for driving scan electrode SC541 through scan electrode SC1080, namely five scan IC 536 through scan IC 540 of odd-numbered electrode output section 53 and five scan IC 546 through scan IC 550 of even-numbered electrode output section 54.

Circuit board 82 is mounted with scan electrode drive circuit 43 except odd-numbered electrode output section 53 and even-numbered electrode output section 54. Circuit board 82 has connector 83a and connector 83b. Required power and signal are supplied to circuit board 81a and circuit board 81b via these connectors.

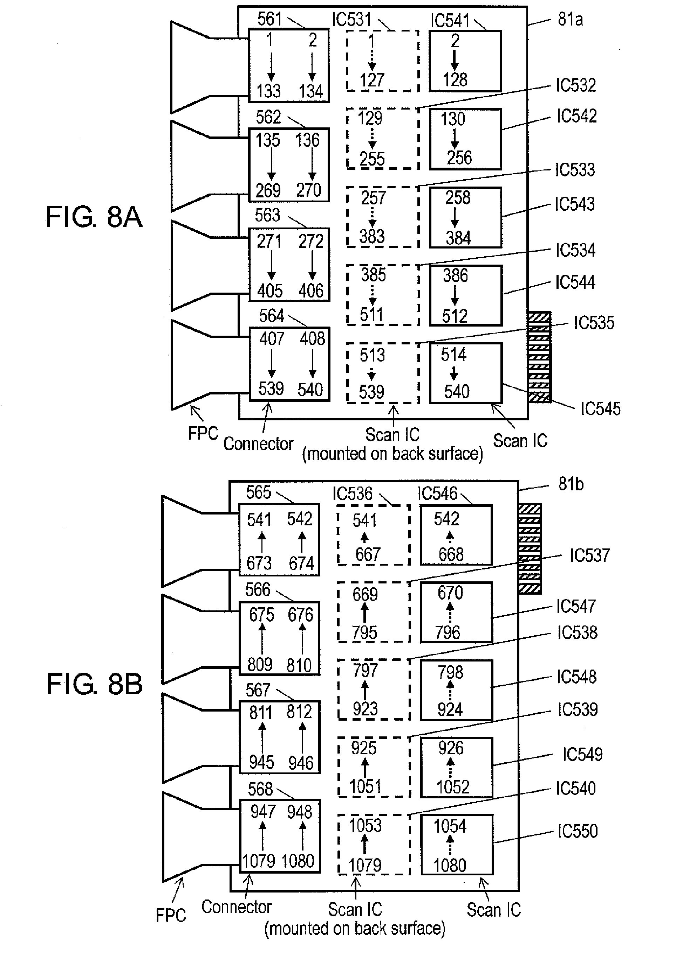

Fig. 8A and Fig. 8B are diagrams showing a circuit board having scan IC 531 through scan IC 550 in accordance with the exemplary embodiment of the present invention. Fig. 8A shows circuit board 81a, and Fig. 8B shows circuit board 81b. In Fig. 8A and Fig. 8B, scan IC 531 through scan IC 550 are referred to as "IC 531" through "IC 550".

In the present embodiment, one surface of circuit board 81a is mounted with five scan IC 531 through scan IC 535 for driving odd-numbered scan electrode SC1, scan electrode SC3, ... , and scan electrode SC539, and the other surface is mounted with five scan IC 541 through scan IC 545 for driving even-numbered scan electrode SC2, scan electrode SC4, ... , and scan electrode SC540. The other surface is mounted with connector 561 through connector 564 for supplying the outputs of scan IC 531 through scan IC 535 and scan IC 541 through scan IC 545 to the panel via a flexible printed circuit (FPC). One surface of circuit board 81b is mounted with five scan IC 536 through scan IC 540 for driving odd-numbered scan electrode SC541, scan electrode SC543, ... , and scan electrode SC1079, and the other surface is mounted with five scan IC 546 through scan IC 550 for driving even-numbered scan electrode SC542, scan electrode SC544, ... , and scan electrode SC1080. The other surface is mounted with connector 565 through connector 568 for supplying the outputs of scan IC 536 through scan IC 540 and scan IC 546 through scan IC 550 to the panel via an FPC. Numerical values attached to scan IC 531 through scan IC 550 and connector 561 through connector 568 show the numbers of the corresponding scan electrodes.

As discussed above, the highest voltage applied to scan electrode SC1 through scan electrode SC1080 in the address period is fourth voltage Vs4, and the lowest voltage is scan pulse voltage Vad as the first voltage. Therefore, the difference is (Vs4 - Vad), and is (150 - (-140)) = 290 (V) in the present embodiment. The output sections of odd-numbered scan electrodes and those of even-numbered scan electrode are separately mounted. In other words, the output sections of odd-numbered scan electrode SC1, scan electrode SC3, ... , and scan electrode SC1079 are mounted on one-side surfaces of circuit board 81a and circuit board 81b, and the output sections of even-numbered scan electrode SC2, scan electrode SC4, ... , and scan electrode SC1080 are mounted on the-other-side surfaces of circuit board 81a and circuit board 81b. Therefore, the largest voltage difference on the same surface of each of the one-side surfaces and the-other-side surfaces is equal to voltage Vscn = 150 (V), and there is no possibility that spark or short circuit occurs between wiring patterns of circuit board 81a and circuit board 81b. The largest voltage difference between terminals of connector 561 through connector 568 or between scan electrode terminals of the panel for connecting the FPC increases, but the largest voltage difference between adjacent scan electrodes can be suppressed to be small as discussed above. Therefore, there is no possibility that spark or short circuit occurs between the electrode terminals of the panel or between the wiring patterns of the printed boards. In addition, when the scan ICs corresponding to the odd-numbered scan electrodes and the scan ICs corresponding to the even-numbered scan electrodes are separately mounted, the output sections of scan IC 531 through scan IC 550 can be wired without crossing the terminals of connector 561 through connector 568. As a result, the area for wiring can be suppressed, and the circuit boards can be designed compactly.

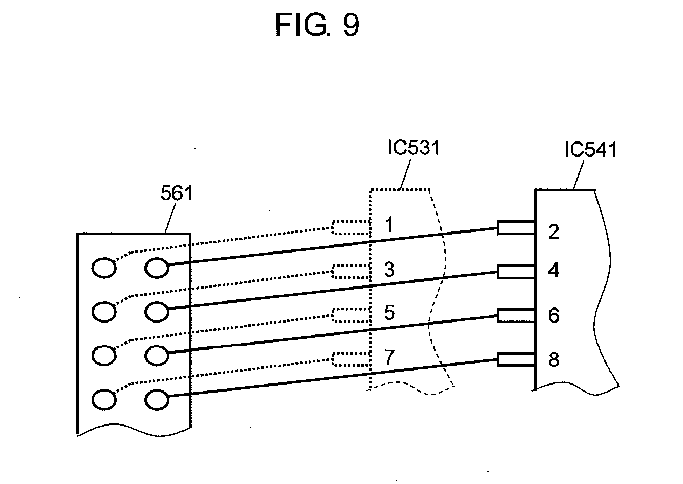

Fig. 9 is a diagram showing a state of the wiring of circuit board 81a in accordance with the exemplary embodiment. Fig. 9 shows scan IC 531 mounted on one surface, scan IC 541 mounted on the other surface, and wiring from the output sections of them to the terminal of connector 561. Fig. 9 is the view from the other surface. In Fig. 9, scan IC 541, connector 561, and the wiring mounted on the one surface are shown by the solid lines, and scan IC 531 and the wiring mounted on the other surface are shown by the broken lines. The terminals of the connectors are inserted into through holes.

Scan IC 351 through scan IC 550 in the present embodiment have a function of reversing the order of 64 scan pulses output from 64 output terminals. By reversing the order of the scan ICs mounted on the one surface and the scan ICs mounted on the other surface, wiring is allowed without crossing. In the present embodiment, odd-numbered scan electrode SC1, scan electrode SC3, ... , and scan electrode SC539 and even-numbered scan electrode SC2, scan electrode SC4, ... , and scan electrode SC540 are scanned in the ascending order. While, odd-numbered scan electrode SC541, scan electrode SC543, ... , and scan electrode SC1079 and even-numbered scan electrode SC542, scan electrode SC544, ... , and scan electrode SC1080 are scanned in the descending order. For responding to this, the order of the scan pulses of the scan ICs mounted on the one surface of circuit board 81a and the scan ICs mounted on the one surface of circuit board 81b is reversed, and the order of the scan pulses of the scan ICs mounted on the other surface of circuit board 81a and the scan ICs mounted on the other surface of circuit board 81b is reversed.

In the present embodiment of the present invention, the scan ICs for applying the scan pulses to the group of odd-numbered scan electrodes are mounted on the one surface, and the scan ICs for applying the scan pulses to the group of even-numbered scan electrodes are mounted on the other surface. Thus, there is no possibility that spark or short circuit occurs between the electrode terminals of the panel or between the wiring patterns of the printed boards, the image display quality is not reduced, and stable address discharge can be generated by preventing the reduction of the wall charge. Respective output sections of scan IC 531 through scan IC 550 can be wired without crossing the terminals of connector 561 through connector 568. As a result, the area for wiring can be suppressed, and the circuit boards can be designed compactly.

In the present embodiment, as shown in Fig. 9, the output sections of the scan ICs mounted on one surface of each of circuit board 81a and circuit board 81b are wired on this surface, and the output sections of the scan ICs mounted on the other surface of each of circuit board 81a and circuit board 81b are wired on this surface. When multi-layer circuit boards having two wiring layers or more are used as circuit board 81a and circuit board 81b, however, the wiring layer for wiring the output sections of the scan ICs for applying the scan pulses to the group of odd-numbered scan electrodes is different from the wiring layer for wiring the output sections of the scan ICs for applying the scan pulses to the group of even-numbered scan electrodes. In this case, in Fig. 8A and Fig. 8B, circuit board 81a and circuit board 81b have two wiring layers or more, the layer mounted with scan IC 541 through scan IC 550 shown by the solid lines is different from the layer mounted with scan IC 531 through scan IC 540 shown by the broken lines. Thus, spark or short circuit can be prevented from occurring between the wiring patterns of the printed boards.

In the present embodiment, using a panel where the data electrodes are divided into data electrodes corresponding to the discharge cells on the upper half of the panel and data electrodes corresponding to the discharge cells on the lower half of the panel, a plasma display device for dividedly and independently driving the upper half of the panel and the lower half of the panel in the address period is described. However, the present invention is not limited to this. Using a panel where data electrode Dj is not divided, the panel may be driven without dividing the panel.

The specific numerical values or the like used in the present embodiment are just one example. Preferably, these values are appropriately set to optimal values in response to the characteristic of the panel, or the specification of the plasma display device.

As is clear from the above-mentioned description, the present invention can provide a plasma display device where there is no possibility that spark or short circuit occurs between the electrode terminals of the panel or between the wiring patterns of the printed boards, the image display quality is not reduced, and stable address discharge can be generated by preventing reduction of the wall charge.

### INDUSTRIAL APPLICABILITY

In the present invention, there is no possibility that spark or short circuit occurs between the electrode terminals of the panel or between the wiring patterns of the printed boards, the image display quality is not reduced, and stable address discharge can be generated by preventing reduction of the wall charge. Therefore, the present invention is useful as a plasma display device.

## Claims

1. A plasma display device comprising:
a plasma display panel having a plurality of scan electrodes; and
a drive circuit having a circuit board including a scan IC for applying scan pulses to the plurality of scan electrodes,
wherein the drive circuit divides the plurality of scan electrodes into a group of odd-numbered scan electrodes and a group of even-numbered scan electrodes individually,
wherein, one surface of the circuit board including the scan IC is mounted with a scan IC for applying scan pulses to the group of odd-numbered scan electrodes, and the other surface of the circuit board is mounted with a scan IC for applying scan pulses to the group of even-numbered scan electrodes.

2. The plasma display device of claim 1, wherein
one field period is constituted by a plurality of subfields having an odd address period and an even address period, scan pulses being sequentially applied to scan electrodes that belong to the group of odd-numbered scan electrodes in the odd address period, scan pulses being sequentially applied to scan electrodes that belong to the group of even-numbered scan electrodes in the even address period, and
in at least one of the odd address period and the even address period,
the drive circuit sequentially applies scan pulses to scan electrodes that belong to a scan electrode group to which the scan pulses are applied, voltage of the scan pulses varying from second voltage higher than scan pulse voltage to the scan pulse voltage, and varying to the second voltage again,
the drive circuit applies one of third voltage higher than the scan pulse voltage and fourth voltage higher than the second voltage and the third voltage to scan electrodes that belong to a scan electrode group to which the scan pulses are not applied, and
the drive circuit applies the third voltage to at least adjacent scan electrodes while the scan pulse voltage is applied.

3. A plasma display device comprising:
a plasma display panel having a plurality of scan electrodes; and
a drive circuit having a circuit board including a scan IC for applying scan pulses to the plurality of scan electrodes,
wherein the drive circuit divides the plurality of scan electrodes into a group of odd-numbered scan electrodes and a group of even-numbered scan electrodes individually,
wherein the circuit board having the scan IC is a multi-layer circuit board having two wiring layers or more, and a wiring layer for wiring an output section of a scan IC for applying scan pulses to the group of odd-numbered scan electrodes is different from a wiring layer for wiring an output section of a scan IC for applying scan pulses to the group of even-numbered scan electrodes.
